# EUROPEAN PATENT APPLICATION

(11) **EP 4 002 499 A1**
(43) Date of publication of application: **25.05.2022**
(21) Application number: 21206352.3
(22) Date of filing: 04.11.2021
(51) Int. Cl.: H01L 33/56

(54) **BONDING AND SEALING MATERIAL, AND LID FOR OPTICAL DEVICE PACKAGE**

(30) Priority: 12.11.2020 JP 2020188426
(71) Applicant: Shin-Etsu Chemical Co., Ltd., Tokyo 100-0005 (JP)
(72) Inventor: MATSUI, Harunobu, Joetsu-shi (JP); HARADA, Daijitsu, Joetsu-shi (JP); TAKEUCHI, Masaki, Joetsu-shi (JP)
(74) Representative: Mewburn Ellis LLP

(57) **Abstract**

A bonding and sealing material includes, as the essential ingredients, a solder powder, silver nanoparticles coated with a coating material and a solvent, and additionally includes at least one ingredient selected from the group consisting of selenium metal, oxide film inhibitors and oxide film removers. This bonding and sealing material can easily form under mild conditions a metallic adhesive layer having good hermetic sealability and UV resistance of the sort desired when sealing a short-wavelength light-emitting device such as a UV-LED, and can be stably used over a long period of time.

## Description

### TECHNICAL FIELD

The present invention relates to a bonding and sealing material for use in sealing optical devices such as ultraviolet light-emitting diodes (UV LEDs) and short-wavelength, high-power laser light sources that need to be hermetically sealed. The invention also relates to an optical device package lid in which an adhesive layer composed of this bonding and sealing material has been formed beforehand on a window material.

### BACKGROUND

Devices that can emit light in the deep ultraviolet spectrum have received a lot of attention recently in connection with such applications as coronavirus inactivation and water sterilization. Of these, UV LEDs are especially noteworthy as environmentally friendly devices. It is assumed that devices which emit deep ultraviolet light will sometimes, depending on the service environment, be used in harsh environments such as places having a high humidity. At such times, if moisture comes into contact with the electrical circuit where an LED device has been placed, shorting of the circuit may arise. Hence, one performance attribute desired of a package is that it be hermetically sealed.

Currently, when a UV LED is sealed using a conventional resin mold, the resin degrades under the effect of short-wavelength light emitted by the device. Therefore, a surface-mount device package (abbreviated below as "SMD PKG") that uses a lid in which synthetic quartz serves as the window material is most often selected as the optical device package.

When a SMD PKG is hermetically sealed, a metal-based adhesive is used as the sealant for sealing between the lid and the housing member. WO 2016/103547 describes a method which uses as the sealant a gold-tin solder that has proven to be effective in surface acoustic wave (SAW) devices. In cases where an adhesive containing a metallic ingredient such as solder is used, the oxide film formed by the metal leads to a decrease in wettability. To address this, JP-A 2016-078095 describes a method of forming a metallic adhesive layer using a solder metal while removing the oxide film by reflowing with formic acid.

However, the metal-tin solder of WO 2016/103547 generates large stresses in the cooling step following heat application and melting to form a bonding joint, as a result of which the sealability of the bonding joint tends to fail. In addition, there is some risk in terms of the stable supply of material owing to the volatility in the price of gold. As for the method of using formic acid described in JP-A 2016-078095, due to limitations in the working environment and the difficulty of handling formic acid, this approach is not commonly used.

### SUMMARY OF THE INVENTION

It is therefore an object of the present invention to provide a simple and very safe bonding and sealing material which is composed primarily of a metallic material that can create a hermetic seal, which can be used stably for a long time without being affected by heat or short-wavelength light when sealing a device such as an existing UV LED or short-wavelength, high-power laser source, and which enables bonding to be carried out under mild bonding conditions. Another object of the invention is to provide a lid for an optical device package in which an adhesive layer composed of the bonding material has been formed.

As a result of intensive investigations, we have discovered that a composition which includes as the essential ingredients a solder powder, silver nanoparticles coated with a coating material and a solvent and which additionally includes selenium metal or an oxide film inhibitor or remover can be stably used over a long period of time as a package-sealing bonding material capable of hermetically sealing optical devices and moreover can form an adhesive layer under mild bonding conditions.

Accordingly, a first aspect of the invention is directed at a bonding and sealing material which includes, as essential ingredients, a solder powder, silver nanoparticles coated with a coating material and a solvent, and which additionally includes at least one ingredient selected from the group consisting of selenium metal, oxide film inhibitors and oxide film removers.

In a preferred embodiment of the bonding and sealing material according to the first aspect of the invention, the solder powder contains tin. The tin-containing solder powder preferably additionally contains bismuth.

In another preferred embodiment, the bonding and sealing material includes selenium metal and the solder powder has a lower melting point than the selenium metal.

In yet another preferred embodiment, the solder powder further contains one or more element selected from the group consisting of zinc, indium and silver.

In still another preferred embodiment, the coating material is selected from the group consisting of aliphatic carboxylic acids, higher alcohols and amines.

In a further preferred embodiment, the silver nanoparticles have a silver core portion with an average primary particle diameter, calculated as the arithmetic mean value for 20 random coated silver nanoparticles under scanning electron microscopy, of from 20 to 90 nm.

In a yet further preferred embodiment, the solvent includes one or more compound selected from the group consisting of terpenes, monoterpene alcohols, alkyl alcohols and naphthenic hydrocarbons.

In a still further preferred embodiment, the selenium metal has a median particle diameter D₅₀ (volume basis), as determined by dynamic light scattering, of from 5 to 20 µm.

In another preferred embodiment, the bonding and sealing material includes, as the oxide film inhibitor, one or more oxide film inhibitor selected from the group consisting of hindered phenols, hindered amino compounds, hydroquinones and phenothiazine.

In yet another preferred embodiment, the bonding and sealing material includes, as the oxide film remover, one or more oxide film remover selected from the group consisting of aliphatic carboxylic acids and polycarboxylic acids.

A second aspect of the invention is directed at a lid for an optical device package, which lid includes a window material provided in front of a housing member in a direction of light emission by an optical device housed inside the housing member, and a metallic adhesive layer formed on a portion of the window material that adjoins the housing member. The metallic adhesive layer is formed by applying the bonding and sealing material according to the first aspect of the invention in a frame-like shape onto the window material.

In a preferred example of the optical device package lid according to the second aspect of the invention, the window material is synthetic quartz glass.

In another preferred example of the optical device package lid according to the second aspect of the invention, the metallic adhesive layer formed of the bonding and sealing material according to the first aspect of the invention is in a semi-cured state (B-Stage).

### ADVANTAGEOUS EFFECTS

This invention makes it possible to provide a bonding and sealing material which can easily form under mild conditions a metallic adhesive layer having good hermetic sealability and UV resistance of the sort desired when sealing a short-wavelength light-emitting device such as a UV LED, and which can be stably used over a long period of time.

### BRIEF DESCRIPTION OF THE DIAGRAMS

FIG. 1 shows an embodiment of the optical device package lid according to the invention, FIG. 1A being a plan view of the lid, FIG. 1B being a sectional view of the lid along line B-B in FIG. 1A, and FIG. 1C being a simplified cross-sectional view showing an example of an optical device package in which a housing member is closed with the lid.
FIG. 2 is a graph shows the results of thermogravimetric/differential thermal analysis (TG-DTA) measurements on the bonding and sealing material in Example 1.
FIG. 3 is a graph shows the results of TG-DTA measurements on the bonding and sealing material in Example 2.
FIG. 4 is a graph shows the results of TG-DTA measurements on the bonding and sealing material in Example 3.
FIG. 5 is a graph shows the results of TG-DTA measurements on the bonding and sealing material in Example 4.
FIG. 6 is a graph shows the results of TG-DTA measurements on the bonding and sealing material in Comparative Example 1.
FIG. 7 is a graph showing the TG curves obtained by TG-DTA measurement of the bonding and sealing materials of Examples 1 and 2 and Comparative Example 1, the weight change (%) being represented on the vertical axis and the temperature (°C) being represented on the horizontal axis.
FIG. 8 is a backscattered electron image taken with a scanning electron microscope (SEM) showing the cross-section of a film composed of the bonding and sealing material of Example 2.
FIG. 9 is a backscattered electron image taken with a SEM showing the cross-section of a film composed of the bonding and sealing material of Comparative Example 1.

### FURTHER EXPLANATIONS; OPTIONS AND PREFERENCES

The objects, features and advantages of the invention will become more apparent from the following detailed description taken in conjunction with the appended diagrams.

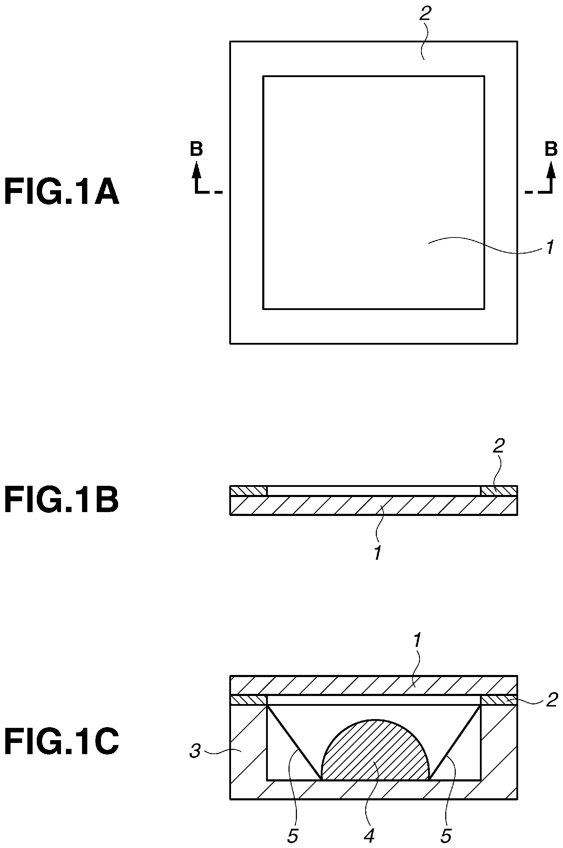

The bonding and sealing material of the invention includes as essential ingredients a solder powder, silver nanoparticles coated with a coating material and a solvent, and additionally includes at least one ingredient selected from the group consisting of selenium metal, oxide film inhibitors and oxide film removers. As shown in FIG. 1, the bonding and sealing material, by being applied in a frame-like shape onto a window material 1 made of a transparent substrate that can transmit light so as to form an adhesive layer 2, can be used to create an optical device lid. For example, it can be suitably used as an optical device package sealant for optical devices such as UV LEDs that require hermeticity.

### Solder Powder

In an optical device package like that in FIG. 1B, when a bonding and sealing material that contains a metallic material is used to bond a window material 1 made of a transparent substrate that can transmit light to a housing member 3 inside of which an optical device 4 has been placed, densifying the adhesive layer 2 is essential for achieving hermeticity. Also, because the optical device 4 has a low heat resistance, it is desired that the solder used in this invention melt at a low temperature to form the adhesive layer 4.

Accordingly, in the course of bonding together, by means of the bonding and sealing material, the window material 1 and the housing member 3 in which the optical device 4 has been placed, in order to bring such bonding to completion at a low temperature (e.g., between 150 and 250°C), it is preferable for the solder powder to have a low melting point. When the above selenium metal is included in the bonding and sealing material of the invention, it is desirable for the solder powder to have a melting point that is lower than the melting point of the selenium metal (221°C). Specifically, the melting point of the solder powder is preferably 200°C or less, more preferably 180°C or less, and even more preferably 160°C or less. The solder powder melting point is generally set to a lower limit of at least 100°C. Although not particularly limited, tin is preferably included in the solder ingredients in order to achieve this temperature range.

Also, although the window material initially exhibits transparency and high transmittivity to short wavelengths such as in the ultraviolet spectrum, when a metal or resin constituent is included among the ingredients making up the window material, deterioration arises from those areas and long-term reliability cannot be obtained. Hence, it is generally preferable to select synthetic quartz as the window material 1. When synthetic quartz is used as the window material 1, in order to achieve reliable adherence thereto, it is even more preferable to include bismuth, which can be fixed by an anchoring effect to synthetic quartz, as a solder ingredient

Such a solder powder, although not particularly limited, preferably includes one or more selected from the group consisting of Sn-Bi solders, Sn-Zn-Bi solders and Sn-In-Ag-Bi solders. Illustrative examples include Sn 42.0 - Bi 58.0 and Sn 88.0 - In 8.0 - Ag 3.5 - Bi 0.5 (Mitsui Mining & Smelting Co., Ltd.), and Sn 89.0 - Zn 8.0 - Bi 3.0 (Sasaki Solder Industry Co., Ltd.).

Because the bonding material is applied by screen printing, to enable the particles to pass through the screen mask mesh, the primary particles of the solder have a D₅₀ (median 50% diameter in volume distribution of particles) that is preferably from 1 to 30 µm, and more preferably from 1 to 20 µm. If the particle size is too small, the specific surface area of the oxide film formed by the metal within the solder ingredients becomes large, raising the possibility that a sufficient effect cannot be obtained even when an antioxidant is included. The median diameter is measured by the dynamic light scattering method.

The solder powder content, although not particularly limited, is preferably at least 30 wt%, and more preferably at least 45 wt%, of the bonding and sealing material, and is preferably not more than 80 wt%, and more preferably not more than 70 wt%.

### Silver Nanoparticles Coated with Coating Material

The metal nanoparticles included in the bonding and sealing material of the invention are very fine particles, and so to prevent spontaneous sintering due interactions among the primary particles, it is necessary to coat the particles with a suitable substance. The metal nanoparticles are thus used in a state, prior to formation of the adhesive layer, where the surfaces have been coated with a coating material (e.g., in a state where a liquid or solid substance has been deposited as a thin layer on the surfaces of the particles).

In this invention, the metal nanoparticles used are silver nanoparticles in which the metal making up the metal nanoparticles is silver, a silver-containing alloy, or a mixture of silver with another metal, although the use of silver nanoparticles in which the metal is substantially made up of silver alone is preferred. In cases where the silver nanoparticles are made of a silver alloy or mixture, from the standpoint of the stability of the sintered body to be formed from the silver nanoparticles, it is preferable for the silver to account for at least 80 wt% of the overall metal nanoparticles.

A known organic material capable of adhering to ordinary metal nanoparticles may be used as the coating material which coats the core particles of the silver nanoparticles (silver core particles). The organic material is exemplified by organic polymers and organic molecules such as aliphatic carboxylic acids, higher alcohols and amines.

The coating material is preferably one that temperature responsively separates from the silver core particles. A sintered body having a high bonding strength can be obtained by release of the coating material from the silver core particles due to rising temperature. For the silver core particles (which are nanoparticles) to be able to sinter rapidly when the coating material has left from the silver core particles, the temperature at which the coating material separates from the silver core particles (separation temperature) is preferably at or above the sintering temperature of the coated silver particles, and more preferably at least 10°C higher than the sintering temperature of the coated silver particles. On the other hand, it is desirable for the coating material separation temperature to be not more than 50°C higher than the sintering temperature of the coated silver particles (i.e., not above (sintering temperature of coated silver particles + 50°C)). Here, the temperature at which the coating material separates from the coated silver particles (separation temperature) may be taken to be the temperature at which necking between the coated silver particles begins. As used herein, "necking" refers to bonding among the silver core particles due to separation of the coating material from the surfaces of the silver core particles. The temperature at which necking begins can be ascertained by determining the weight change that accompanies loss of the coating material from the surface of the silver core particles during necking via thermogravimetric/differential thermal analysis (TG-DTA) measurement and treating the temperature at which the weight changes in the TG curve obtained by TG-DTA measurement as the separation temperature.

As noted above, use can be made of, for example, organic polymers and organic molecules such as aliphatic carboxylic acids, higher alcohols and amines as the coating material that coats the silver core particles. The use of an aliphatic carboxylic acid is especially preferred. Aliphatic carboxylic acids are aliphatic compounds having one or more carboxyl group. The carboxyl groups are generally adsorbed onto and arranged at the surfaces of the silver core particles. For the reasons given above, an aliphatic compound having a structure in which one carboxyl group has been substituted on the compound, that is, a compound having an aliphatic hydrocarbon moiety and one carboxyl group, is preferred.

From the standpoint of being able to promote smooth release of the coating material due to thermal responsiveness when the coating material is rendered into the state of a monomolecular film of uniform density, such as a Langmuir-Blodgett film (LB film), on the surfaces of the silver core particles, the aliphatic hydrocarbon moiety in the aliphatic carboxylic acid is preferably a linear aliphatic hydrocarbon moiety.

Given the hydrophobic interactions, dispersibility and oxidation resistance of the coating material molecules, the number of carbon atoms on the aliphatic moiety in the aliphatic carboxylic acid is preferably at least 5, and more preferably at least 7. On the other hand, taking into account the steric hindrance when the coating material molecules adsorb onto the silver core particles, the number of carbons is preferably 16 or less, and more preferably 13 or less. Specific examples of such aliphatic carboxylic acids include octanoic acid, undecanoic acid and dodecanoic acid. The aliphatic carboxylic acids may be used singly or two or more may be used in combination.

The coated silver nanoparticles have an average primary particle diameter of preferably from 1 to 500 nm, more preferably from 10 to 400 nm, and more preferably from 20 to 300 nm. At an average primary particle diameter within this range, owing to the rise in the absolute number of coating material molecules attached to the particles, hydrophobic interactions between the coating material molecules become larger and the possibility of smooth release difficulties arising can be reduced. The average primary particle diameter of the coated silver nanoparticles is calculated as the arithmetic mean value for 20 random coated silver nanoparticles under scanning electron microscopy. Having the particle diameter be as uniform as possible makes it easier to control the temperature at which release of the coating material occurs, and so it is preferable for the particle size distribution of the coated silver nanoparticles to have a polydispersity in the range of 1.00 to 1.10.

The content of the coated silver nanoparticles in the bonding and sealing material, although not particularly limited, is preferably at least 20 wt%, and more preferably at least 25 wt%, and is preferably not more than 70 wt%, and more preferably not more than 50 wt%.

### Silver Core Particles

The average primary particle diameter of uncoated silver core particles, although not particularly limited, may be suitably selected from the standpoint of, for example, the sintering temperature. Specifically, the average primary particle diameter of the silver core particles can be suitably selected within a range of up to 90 nm; to carry out low-temperature sintering, an average primary particle diameter of 80 nm or less is more preferred. The average primary particle diameter of the silver core particles is generally at least 1 nm; in terms of the cost of silver nanoparticle production, the average primary particle size is more preferably at least 20 nm. The average primary particle diameter of the silver core particles is calculated as the arithmetic mean value for 20 random silver core particles under scanning electron microscopy (SEM).

The shape of the silver core particles is not particularly limited, although a spherical shape, which is a conformation that facilitates release of the coating material, is preferred.

### Solvent

The solvent in the bonding and sealing material of the invention may be suitably selected from among solvents capable of dispersing the solder powder, the coated silver nanoparticles, and the subsequently described selenium metal, oxide film inhibitor or oxide film remover. For example, a solvent containing one or more compound selected from terpenes, monoterpene alcohols, alkyl alcohols and naphthenic hydrocarbons may be used. Of these, although not particularly limited, from the standpoint of the chemical stability and dispersibility of the substances included in the bonding and sealing material, it is preferable to include one or more selected from the group consisting of aliphatic amine-type solvents, aliphatic alcohol-type solvents, terpin acetate-type solvents, aliphatic alkane-type solvents and carbitol-type solvents. The solvent may be of one type used alone or two or more may be combined and used as a mixed solvent.

Specific examples of aliphatic amine-type solvents include octylamine, dodecylamine and oleylamine. Specific examples of aliphatic alcohol-type solvents include hexanol, octanol, decanol and dodecanol. Specific examples of terpin acetate-type solvents include 1,8-terpin-1-acetate, 1,8-terpin-8-acetate and 1,8-terpin-1,8-diacetate. Specific examples of aliphatic alkane-type solvents include octane, decane and dodecane. Specific examples of carbitol-type solvents include butyl carbitol and hexyl carbitol.

When the bonding and sealing material to be applied by screen printing, taking into account the compatibility with the screen mask emulsion and the pattern precision, the solvent preferably includes a terpin acetate-type solvent. Examples of terpin acetate-type solvents that may be used include Terusolve THA-90 and Terusolve THA-70 from Nippon Terpene Chemicals, Inc.

The solvent content with respect to the overall composition of the bonding and sealing material of the invention is preferably from 1 to 30 wt%, and more preferably from 5 to 20 wt%. A solvent content within this range can lessen the possibility of the bonding and sealing material departing from a suitable viscosity during screen printing and thus making accuracy of the pattern to be printed difficult to achieve.

### Selenium Metal

When a sealant that uses a metallic material is bonded under applied heat and pressure in an open-air atmosphere, the thermal energy causes oxygen in the open air to react exothermally with the metal species serving as a constituent, creating an oxide and thus forming an oxide film on the surface. This oxide film is thought to be a factor that impedes wettability of the bonding and sealing material ingredients and interferes with densification of the adhesive layer. For this reason, the bonding and sealing material of the invention includes a substance that hinders the reaction of oxygen with the metal serving as a constituent of the bonding and sealing material, thereby inhibiting oxide film formation.

Selenium is a group 16 element in the periodic table. Given the electron shell and electron orbitals of the atom, it is similar in nature to oxygen. Accordingly, it is thought that, for example, instead of oxygen bonding to silver to form silver oxide, by having selenium bond to silver, a compound such as silver selenide can be formed. Selenium is regarded as having an antioxidative effect which impedes the bonding of metal and oxygen.

In the bonding and sealing material of the invention, in order to carry out bonding under mild bonding conditions, it is preferable, for example, to be able to bond well under what are, ultimately, relatively low temperature conditions of 250°C or below. Selenium, which has a bulk melting point of 221°C, melts in the course of bonding, and is also expected to form alloys with other metallic species. Due to alloying, the temperature at which remelting occurs most likely rises, thereby resolving the problem of heat resistance as well.

When selenium metal is added as an antioxidant to the bonding and sealing material of the invention, in order to obtain a necessary and sufficient antioxidative effect and to avoid the problem of all the selenium not being entirely absorbed when another metallic species is reacted with selenium to form an alloy, the amount of addition, although not particularly limited, is preferably from 0.5 to 5 wt%, and more preferably from 1 to 3 wt%. Taking into account the size of the mesh openings in the screen mask when screen printing is used, the median particle diameter D₅₀ (volume basis) of the selenium metal added, as measured by dynamic light scattering, is preferably from 5 to 20 µm, and more preferably from 5 to 10 µm. The selenium metal used may be, for example, SEE01PB (Kojundo Chemical Laboratory Co. Ltd.).

### Oxide Film Inhibitor

Another effective method for preventing oxidation of the metal species that is a constituent of the inventive bonding and sealing material is to use an organic substance to prevent the formation of an oxide film. One or more oxide film inhibitor selected from the group consisting of hindered phenols, hindered amines, hydroquinones and phenothiazines may be included as the oxide film inhibitor at this time. Additives, including such oxide film inhibitors, that can be used in the inventive bonding and sealing material may be suitably selected from among those which are soluble or dispersible in the above solvent. However, additives which include sulfur in the structure should be avoided as much as possible because they may induce sulfurization of the silver.

Illustrative examples of hindered phenols include Irganox 1010, Irganox 1076, Irganox 1135 (all from BASF Japan), and ADK Stab AO series (from Adeka Corporation). Hindered amine light stabilizers (HALS) may be used as the above hindered amines; specific examples include TMPS-E (Shin-Etsu Chemical Co., Ltd.) and ADK Stab LA series (Adeka Corporation). Specific examples of hydroquinones include hydroquinone and 4-methoxyphenol (MEHG).

In cases where an oxide film inhibitor is added to the bonding and sealing material of the invention, to obtain a sufficient antioxidative effect and also to prevent residual organic substance from remaining in the adhesive layer after bonding and becoming a cause of degradation when irradiated with UV light, the amount of addition is preferably from 0.5 to 10 wt%, and more preferably from 1 to 5 wt%.

### Oxide Film Remover

It is assumed that the bonding and sealing material of the invention will be used for bonding in an open-air environment. That is, it will be used in an environment where an unlimited amount of oxygen is supplied, which suggests that oxidation of the metallic species serving as a constituent of the bonding and sealing material may be unavoidable. Hence, to improve the wettability of constituents during bonding that is necessary for the bonding material to have hermetic sealability, it is preferable to include an oxide film remover which removes the oxide film that is a factor impeding wettability.

Acidic substances having carboxyl groups within the molecular structure, such as aliphatic carboxylic acids or polycarboxylic acids, are preferred as oxide film removers for removing an oxide film of the metallic species serving as a constituent in the bonding and sealing material of the invention. Also, to smoothly induce an oxide film-removing chemical reaction, it is preferable for the carboxyl groups to be at the ends of the main chain.

Specific examples of the oxide film remover include acetic acid, propionic acid, caproic acid, caprylic acid, lauric acid, palmitic acid, stearic acid, oleic acid, linoleic acid, linolenic acid, glutamic acid, aspartic acid, *N*-Lauroyl-sarcosinate, *N*-Cocoyl sarcosinate and *N*-oleoyl sarcosinate.

When an oxide film remover is added to the bonding and sealing material of the invention, in order to obtain a sufficient oxide film-removing effect and also to prevent a decrease in bonding strength due to a rise in metal wettability after bonding, the amount of addition is preferably from 0.5 to 10 wt%, and more preferably from 1 to 5 wt%.

### Lid for Optical Device Package

A lid for an optical device package can be obtained by applying the bonding and sealing material of the invention onto a housing member-adjoining portion of a transparent substrate which can transmit light and serves as a window material.

The optical device package lid, as shown in the cross-sectional and top views in FIGS. 1A to 1C, has an adhesive layer 2 that is formed on a surface of a window material 1, such as an outer peripheral edge of a principal surface of the window material 1 where it adjoins the housing member 3 of the optical device 4. Aside from the principal surfaces of the window material, this adhesive layer 2 may be formed on sidewalls, although it is preferably formed only on the principal surfaces, particularly only one principal surface adjoining the housing member 3 which houses the optical device 4. Also, the adhesive layer 2 is preferably formed on the outer peripheral edge of the principal surface of the window material 1 such that, as shown in FIGS. 1A and 1B, light can be extracted from the central portion of the window material 1, although it is not always necessary for the adhesive layer 2 to be formed up to the outer peripheral edge of the window material 1. In addition, the adhesive layer 2 should be formed at a position that allows for a suitable region where light can be extracted at the central portion of the window material 1, and with a shape and surface area sufficient for hermetic sealing.

In the optical device package lid of the invention, the above-described bonding and sealing material of the invention is applied onto, for example, a portion of the window material 1 which adjoins the housing member 3 to form the adhesive layer 2. In cases where the bonding and sealing material that forms this adhesive layer 2 is to be placed in a semi-cured state (B-Stage), this may be done by heating the adhesive layer 2 at between 100°C and 180°C for a period of from 5 to 60 minutes.

The window material 1 is not particularly specified, so long as it is a transparent body capable of transmitting light. The wavelength of the light-emitting device 4 placed in the housing member 3 is not particularly limited, although in the case of, for example, a UV LED within which is enclosed a device that emits ultraviolet light, the window material 1 is preferably synthetic quartz that transmits short wavelength light at a high transmission. Because synthetic quartz exhibits a high transmission over a broad wavelength range, it can be employed in light-emitting devices that emit light in the visible light region and in the near-infrared and infrared regions.

By using such an optical device package lid in which is formed an adhesive layer 2 made of the inventive bonding and sealing material, as shown in FIG. 1C, for example, it is possible to construct an optical device package that has an optical device 4 and a housing member 3 which houses therein the optical device 4 and wherein the window material 1 and the housing member 3 are bonded together by the inventive bonding and sealing material that has been applied onto the optical device package lid, thereby hermetically sealing the optical device 4 within the housing member 3. In FIG. 1C, the reference number 5 denotes a reflector.

Bonding between the window material 1 and the housing member 3 may be carried out as follows. First, the housing member 3 in which the optical device 4 has been placed and the adhesive layer 2 are brought into contact, thus determining the bonding position, following which the optical device package lid and the housing member 3 can be bonded together by heat treatment. The temperature of such heat treatment (curing temperature), from the standpoint of the heat resistance of the optical device sealed inside the optical device package, is preferably at least 150°C, and more preferably at least 170°C, and is preferably not more than 250°C, more preferably not more than 220°C, and even more preferably not more than 200°C. The heat treatment time is preferably from 10 seconds to 60 minutes. It is preferable to carry out pressurization at the same time; the atmosphere in such treatment may be, for example, an open-air atmosphere, an inert gas atmosphere or a nitrogen gas atmosphere. In the case of an optical device package lid in which the bonding and sealing material that forms the adhesive layer 2 is in a semi-cured state (B-Stage), the adhesive layer 2 flattens due to heating and the silver nanoparticles included in the bonding and sealing material densely bond with one another, enabling a highly hermetic seal to be created.

In the optical device package lid of the invention, although not particularly limited, it is preferable to provide also a heat annealing step that carries out heat treatment after the window material 1 and the housing member 3 in which the optical device 4 has been placed have been bonded and integrally united by the adhesive layer 2. This heat annealing step makes bonds between the silver nanoparticles within the adhesive layer 2 formed of the inventive bonding and sealing material and bonds between the silver nanoparticles and the solder powder more secure, increasing the bonding strength. The heat annealing temperature is preferably a temperature at least 20°C higher than the curing temperature (the temperature of the above heat treatment), and more preferably a temperature not more than 100°C higher than the curing temperature (curing temperature + 100°C or less). Although there is no particular upper limit in the heat annealing temperature, from the standpoint of the heat resistance of the optical device 4 sealed inside the optical device package, a temperature of 250°C or less is preferred. The heat annealing time, from the standpoint of heat build-up in the optical device 4 and productivity, is preferably from 10 to 180 minutes.

### EXAMPLES

The following Examples and Comparative Examples are provided to illustrate the invention, but are not intended to limit the scope thereof.

### Example 1

A bonding and sealing material was prepared by mixing together 23 wt% of silver nanoparticles obtained by coating the surface of silver core particles having an average primary particle diameter of 61 nm with undecanoic acid, 65 wt% of Sn 42 - Bi 58 solder powder having a median particle diameter D₅₀ (volume basis) as determined by dynamic light scattering (ST-5, Mitsui Mining & Smelting Co., Ltd.) of 5.7 µm, 10 wt% of Terusolve THA-70 (Nippon Terpene Chemicals, Inc.) as the solvent, and 2 wt% of selenium metal having a median particle diameter D₅₀ (volume basis) as determined by dynamic light scattering of 8.3 µm. The average primary particle diameter of the silver core particles was calculated as the arithmetic mean value for 20 random silver core particles under scanning electron microscopy (SEM).

### Example 2

A bonding and sealing material was prepared by mixing together 24 wt% of silver nanoparticles obtained by coating the surface of silver core particles having an average primary particle diameter of 61 nm with undecanoic acid, 65 wt% of Sn 42 - Bi 58 solder powder having a median particle diameter D₅₀ (volume basis) as determined by dynamic light scattering (ST-5, from Mitsui Mining & Smelting Co., Ltd.) of 5.7 µm, 10 wt% of Terusolve THA-70 (Nippon Terpene Chemicals, Inc.) as the solvent and 1 wt% of *N*-oleoyl sarcosinate.

### Example 3

A bonding and sealing material was prepared by mixing together 21 wt% of silver nanoparticles obtained by coating the surface of silver core particles having an average primary particle diameter of 58 nm with octanoic acid, 64 wt% of Sn 42 - Bi 58 solder powder having a median particle diameter D₅₀ (volume basis) as determined by dynamic light scattering (ST-3, from Mitsui Mining & Smelting Co., Ltd.) of 3.4 µm, 12 wt% of decanol as the solvent and 3 wt% of selenium metal having a median particle diameter D₅₀ (volume basis) as determined by dynamic light scattering of 8.3 µm.

### Example 4

A bonding and sealing material was prepared by mixing together 26 wt% of silver nanoparticles obtained by coating the surface of silver core particles having an average primary particle diameter of 58 nm with undecanoic acid, 60 wt% of Sn 88.0 - In 8.0 - Ag 3.5 - Bi 0.5 solder powder having a median particle diameter D₅₀ (volume basis) as determined by dynamic light scattering (ST-5, from Mitsui Mining & Smelting Co., Ltd.) of 5.8 µm, 12 wt% of a 1:1 mixed solvent of hexanol and decanol as the solvent and 2 wt% of Irganox 1010 (BASF Japan).

### Comparative Example 1

A bonding and sealing material was prepared by mixing together 24 wt% of silver nanoparticles obtained by coating the surface of silver core particles having an average primary particle diameter of 61 nm with undecanoic acid, 65 wt% of Sn 42 - Bi 58 solder powder having a median particle diameter D₅₀ (volume basis) as determined by dynamic light scattering (ST-5, from Mitsui Mining & Smelting Co., Ltd.) of 5.7 µm and 11 wt% of Terusolve THA-70 (Nippon Terpene Chemicals, Inc.) as the solvent.

### Verification of Oxide Film Inhibiting/Removing Effect

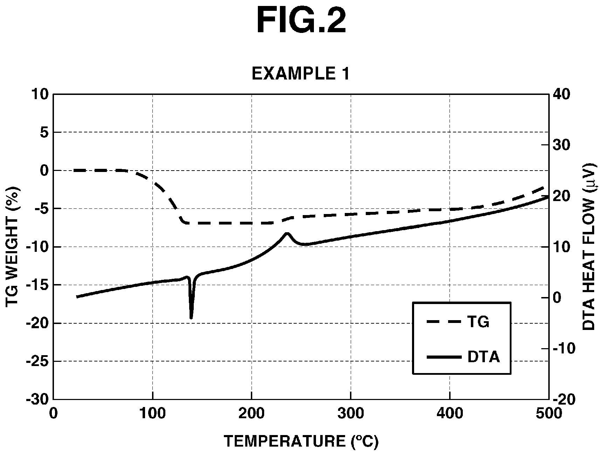

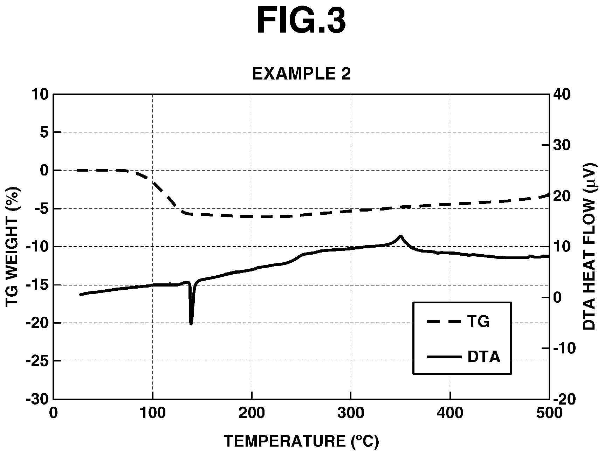

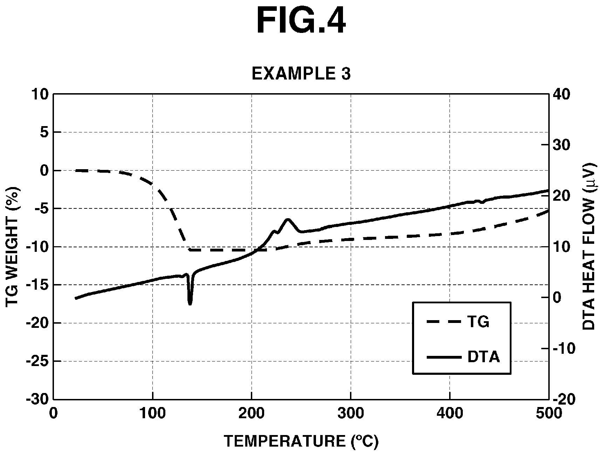

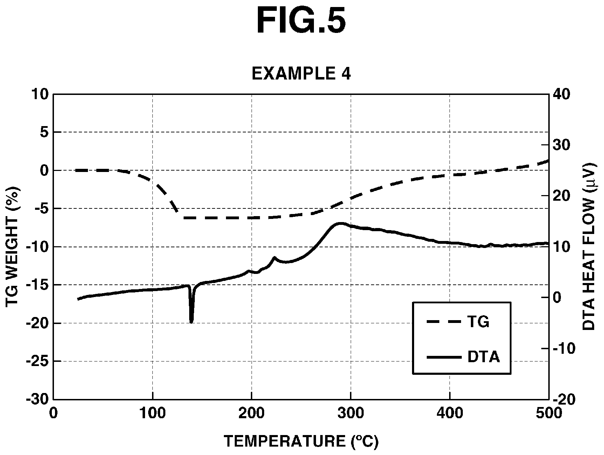

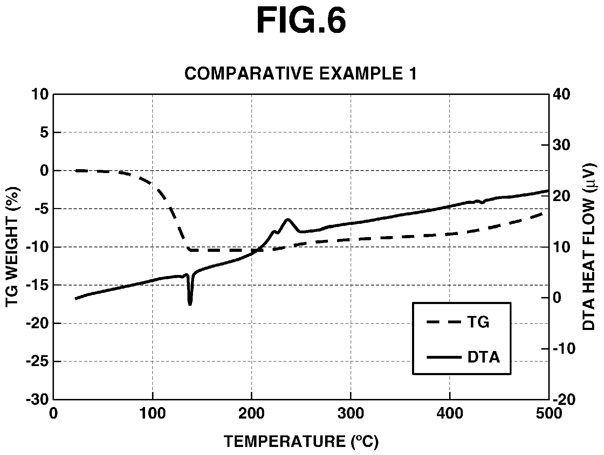

TG-DTA measurements were carried out on each of the resulting bonding and sealing materials under open-air conditions and at a temperature rise rate of 5°C/min. Measurement results for the bonding and sealing materials in Examples 1 to 4 and Comparative Example 1 are shown in FIGS. 2 to 6. It is apparent from these results that, using as the control the bonding and sealing material of Comparative Example 1 (FIG. 6) in which no oxide film inhibitor or remover was added, in cases where selenium metal or an oxide film inhibitor or remover was added (the bonding and sealing materials of Examples 1 to 4; see FIGS. 2 to 5), changes arose in the TG-DTA curve.

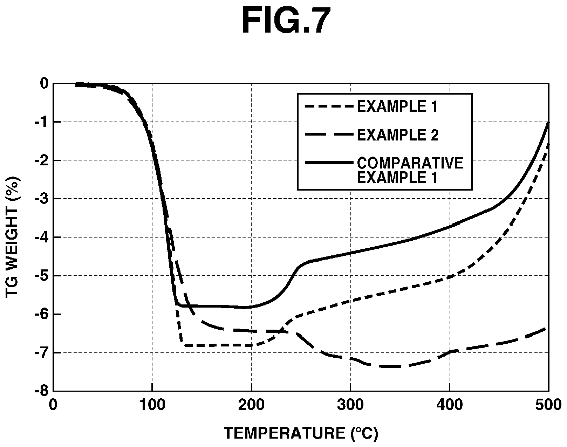

FIG. 7 shows TG curves for the bonding and sealing materials in Examples 1 and 2 and Comparative Example 1, the change in weight being represented on the vertical axis and the temperature being represented on the horizontal axis. As is apparent in FIG. 7, the compositions in Examples 1 and 2 in which selenium metal or an oxide film remover was added show little change in weight compared with Comparative Example 1 and effectively prevent oxidation of the metallic substance used in the bonding and sealing material of the invention.

### Optical Device Package Lid

The bonding and sealing materials prepared in Examples 1 to 4 and Comparative Example 1 were applied by screen printing onto one side of a synthetic quartz glass substrate in a 3.4 mm square window frame-like shape having a linewidth of 250 µm and a thickness of 30 µm, thereby forming an adhesive layer. The synthetic quartz glass substrate on which the adhesive layer had been formed was subsequently heated at 130°C for 20 minutes, rendering the adhesive layer into a semi-cured state (B-Stage). The synthetic quartz glass substrate was then diced along the outer periphery of the 3.4 mm square window frame-shaped adhesive layer to give, in the manner shown in FIGS. 1A and 1B, an optical device package lid (synthetic quartz glass lid) having a synthetic quartz glass window material 1 and an adhesive layer 2.

### Evaluation of Adhesive Layer during Bonding

In the manner shown in FIG. 1C, using as the housing member 3 an SMD package carrier which is made of aluminum nitride that has been gold-plated on the bonding surface and which has a cavity for receiving an optical device, a UVC LED that emits 285 nm light or a photodiode (a light-receiving device) was placed as the optical device 4 in the cavity.

The synthetic quartz glass lid on which was formed an adhesive layer 2 made of, variously, the bonding and sealing materials of Examples 1 to 4 and Comparative Example 1 was set on this housing member 3 so as to cover the cavity in which the optical device 4 had been placed, and the window material 1 and housing member 3 were bonded together by applying heat and pressure for 3 minutes under conditions of 150°C and 200 g/package. Heat annealing was then carried out for 60 minutes in a 250°C electric furnace, giving an optical device package. The adhesive layer of the resulting optical device package was evaluated by means of the following tests. Evaluation was carried out on 50 test samples created for each test.

### Penetrant Inspection

The optical device package was immersed for 24 hours in Micro-Check Penetrant JIP 143 (Ichinen Chemicals Co., Ltd.), and then washed with acetone and examined under a microscope. This penetrant inspection was carried out before and after the subsequently described evaluation of resistance to ultraviolet light. Test samples in which infiltration of the penetrant to the package interior was not observed passed inspection.

### Gross Leak Test

A gross leak test using a fluorinated solvent having high penetrability was performed in accordance with U.S. MIL-STD-883 Test Method 1014. The optical device package was immersed for 2 minutes in the fluorinated solvent FC-43 (Sumitomo 3M Ltd.) heated to 120°C, and the presence or absence of solvent infiltration to the interior of the optical device package was determined with a microscope. Test samples in which infiltration of the solvent to the package interior was not observed passed inspection.

### Fine Leak Test

A fine leak test using helium was performed in accordance with U.S. MIL-STD-883 Test Method 1014. First, the optical element package was placed at rest in a vacuum for one hour, then it was placed at rest for 6 hours in a 0.3 MPa helium gas atmosphere, after which the helium leak rate was measured with a helium leak tester. However, because synthetic quartz glass itself has a tendency to absorb helium, the passing threshold was relaxed somewhat; test samples in which the helium leak rate was 5×10⁻⁸ atm cc/sec or less were regarded as passing inspection.

### Evaluation of Resistance to Ultraviolet Light

When the optical device was a UVC LED, the bonding state was examined and a penetrant inspection and gross leak test were performed after the UVC LED within the optical device package had been lit for 5,000 hours. When the optical device was a photodiode (light-receiving device), the bonding state was examined and a penetrant inspection and gross leak test were performed after 5,000 hours of ultraviolet irradiation, from above the window material in the optical element package, with a UVC LED that emits 285 nm light.

### Evaluation Results

The pass rates for the samples created in each Example are shown below.

**Table 1**

| Test | Example 1 | Example 2 | Example 3 | Example 4 | Comparative Example 1 |
|---|---|---|---|---|---|
| Penetrant inspection (before UV irradiation) | 100% | 100% | 100% | 100% | 100% |
| Penetrant inspection (after UV irradiation) | 100% | 100% | 100% | 100% | 100% |
| Gross leak | 100% | 100% | 100% | 100% | 52% |
| Fine leak | 100% | 100% | 100% | 100% | 30% |

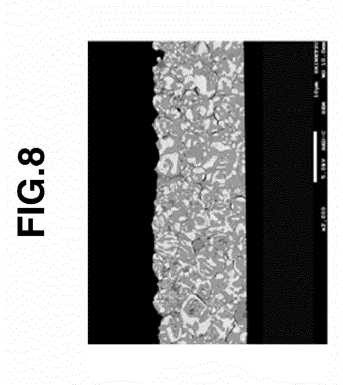

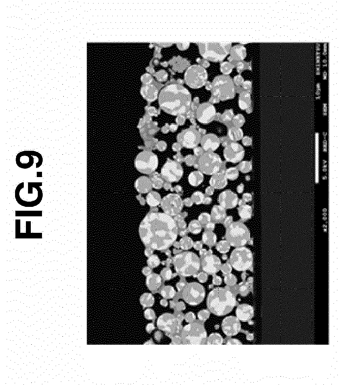

Cross-sections of the films formed by heating the bonding and sealing materials of Example 2 and Comparative Example 1 in an unloaded state for 3 minutes at 150°C in open air were examined. Scanning electron micrographs of the film cross-sections are shown in FIGS. 8 and 9.

As shown in FIGS. 8 and 9, the sample film obtained from the bonding and sealing material of Example 1 (FIG. 8) forms a dense film in which the bonding and sealing material has fully melted and mixed. On the other hand, in the sample film formed of the bonding and sealing material of Comparative Example 1, the metal constituent making up the bonding and sealing material forms an oxide film; hence, some metal remains in the form of particles and so the film is clearly not in a fully dense state.

Japanese Patent Application No. 2020-188426 is incorporated herein by reference.

Although some preferred embodiments have been described, many modifications and variations may be made thereto in light of the above teachings. It is therefore to be understood that the invention may be practiced otherwise than as specifically described without departing from the scope of the appended claims.

## Claims

1. A bonding and sealing material comprising, as essential ingredients, a solder powder, silver nanoparticles coated with a coating material and a solvent, and additionally comprising at least one ingredient selected from the group consisting of selenium metal, oxide film inhibitors and oxide film removers.

2. The bonding and sealing material of claim 1, wherein the solder powder contains tin.

3. The bonding and sealing material of claim 1 or 2 which includes selenium metal and wherein the solder powder has a lower melting point than the selenium metal.

4. The bonding and sealing material of claim 2 or 3, wherein the tin-containing solder powder additionally contains bismuth.

5. The bonding and sealing material of claim 4, wherein the solder powder further contains one or more element selected from the group consisting of zinc, indium and silver.

6. The bonding and sealing material of any one of claims 1 to 5, wherein the coating material is selected from the group consisting of aliphatic carboxylic acids, higher alcohols and amines.

7. The bonding and sealing material of any one of claims 1 to 6, wherein the silver nanoparticles have a silver core portion with an average primary particle diameter, calculated as the arithmetic mean value for 20 random coated silver nanoparticles under scanning electron microscopy, of from 20 to 90 nm.

8. The bonding and sealing material of any one of claims 1 to 7, wherein the solvent includes one or more compound selected from the group consisting of terpenes, monoterpene alcohols, alkyl alcohols and naphthenic hydrocarbons.

9. The bonding and sealing material of any one of claims 1 to 8, wherein the selenium metal has a median particle diameter D₅₀ (volume basis), as determined by dynamic light scattering, of from 5 to 20 µm.

10. The bonding and sealing material of any one of claims 1 to 9 which includes, as the oxide film inhibitor, one or more oxide film inhibitor selected from the group consisting of hindered phenols, hindered amino compounds, hydroquinones and phenothiazine.

11. The bonding and sealing material of any one of claims 1 to 10 which includes, as the oxide film remover, one or more oxide film remover selected from the group consisting of aliphatic carboxylic acids and polycarboxylic acids.

12. A lid for an optical device package, comprising a window material provided in front of a housing member in a direction of light emission by an optical device housed inside the housing member, and a metallic adhesive layer formed on a portion of the window material that adjoins the housing member, wherein the metallic adhesive layer is formed by applying the bonding and sealing material of any one of claims 1 to 11 in a frame-like shape onto the window material.

13. The optical device package lid of claim 12, wherein the window material is synthetic quartz glass.

14. The optical device package lid of claim 12 or 13, wherein the metallic adhesive layer formed of the bonding and sealing material of any one of claims 1 to 11 is in a semi-cured state (B-Stage).
